# EUROPEAN PATENT APPLICATION

(11) **EP 1 361 605 A1**
(43) Date of publication of application: **12.11.2003**
(21) Application number: 02715873.2
(22) Date of filing: 22.01.2002
(51) Int. Cl.: H01L 21/316, H01L 21/318, H01L 21/31

(54) **METHOD FOR PRODUCING MATERIAL OF ELECTRONIC DEVICE**

(30) Priority: 22.01.2001 JP 2001012917
(71) Applicant: TOKYO ELECTRON LIMITED, Minato-ku, Tokyo 107-8481 (JP)
(72) Inventor: SUGAWARA, Takuya, C/O TOKYO ELECTRON LIMITED, Nirasaki-shi, Yamanashi 407-0192 (JP); NAKANISHI, Toshio, C/O TOKYO ELECTRON LIMITED, Amagasaki-shi, Hyogo 660-0891 (JP); OZAKI, Shigenori, C/O TOKYO ELECTRON LIMITED, Amagasaki-shi, Hyogo 660-0891 (JP); MATSUYAMA, Seiji, C/O TOKYO ELECTRON LIMITED, Nirasaki-shi, Yamanashi 407-0192 (JP); MURAKAWA, Shigemi, C/O TOKYO ELECTRON LIMITED, Tokyo 107-8481 (JP); TADA, Yoshihide, C/O TOKYO ELECTRON LIMITED, Nirasaki-shi, Yamanashi 407-0192 (JP)
(74) Representative: Liesegang, Eva
(86) International application number: JP0200439
(87) International publication number: WO02058130

(57) **Abstract**

A process for producing electronic device (for example, high-performance MOS-type semiconductor device) structure having a good electric characteristic, wherein an SiO₂ film or SiON film is used as an insulating film having an extremely thin (2.5 nm or less, for example) film thickness, and poly-silicon, amorphous-silicon, or SiGe is used as an electrode. In the presence of process gas comprising oxygen and an inert gas, plasma including oxygen and the inert gas (or plasma comprising nitrogen and an inert gas, or plasma comprising nitrogen, an inert gas and hydrogen) is generated by irradiating a wafer W including Si as a main component with microwave via a plane antenna member SPA. An oxide film (or oxynitride film) is formed on the wafer surface by using the thus generated plasma, and as desired, an electrode of poly-silicon, amorphous-silicon, or SiGe is formed, to thereby form an electronic device structure.

## Description

### Technical Field

The present invention relates to a process which is suitably usable for the production of materials to be used for electronic devices. The process for producing a material for electronic device according to the present invention may be used, for example, for forming a material to be used for a semiconductor or semiconductor device (for example, those having an MOS-type semiconductor structure).

### Background art

In general, the production process according to the present invention is widely applicable to the production of materials for electronic device such as semiconductors or semiconductor devices, and liquid crystal devices. For the convenience of explanation, however, the background art relating to semiconductor devices as an example of the electronic devices, will be described here.

Along with the requirement for the fabrication of finer patterns in semiconductor devices in recent years, the demand for a high-quality silicon oxide film (SiO₂ film) has been increased remarkably. For example, with respect to the MOS-type semiconductor structure, as the most popular semiconductor device structure, in accordance with the so-called scaling rule, the demand for an extremely thin (e.g., the thickness on the order of 2.5 nm or less) and high-quality gate insulator (SiO₂ film) becomes extremely high.

Heretofore, as the materials for such gate insulators, there have industrially been used silicon oxide films (SiO₂ films) which have been obtained by directly oxidizing a silicon substrate (or base material) by use of a high-temperature heating furnace of about 850 °C to 1000 °C.

However, when the conventional thin gate insulator is simply intended to be thinned so as to provide a thickness thereof of 2.5 nm or less, the leakage current passing through the gate insulator (gate leakage current) becomes strong, and it causes some problems such as increase in the electric power consumption and acceleration of the deterioration in the device characteristics.

In addition, when the conventional thin gate insulator is used, boron atoms which have been incorporated into the gate electrode during the formation of a gate electrode, will penetrate through the SiO₂ film to reach the silicon substrate as the material underlying the gate insulator, to thereby cause a problem of deteriorating the semiconductor device characteristic. As one means for solving such a problem, the use of an oxynitride film (SiON film) as the gate insulator material has been investigated.

However, when such an SiON film is simply and directly formed by using a heat oxynitriding process, a large number of nitrogen atoms are incorporated in the interface thereof with the silicon substrate, whereby the resultant device characteristics is inevitably liable to be deteriorated. In addition, in the case of the SiO₂/SiN stack structure which has been obtained by combining a thermal oxidation film with an SiN film formation due to CVD (chemical vapor deposition process), traps for carriers are generated in the SiO₂/SiN interface, whereby the device characteristics are liable to be deteriorated. Therefore, in the case of such an SiON film formation, it is considered to be promising to nitride an SiO₂ film by using plasma. In general, this is because the plasma nitridation (or nitriding) is liable to provide a high-quality gate oxynitride film having a small interface state and having a high nitrogen content (several percents) in the oxide film surface portion. In addition, the use of plasma is also advantageous because it is easy to conduct the nitridation at a low temperature.

On the other hand, when an SiO₂ film is intended to be nitrided by heating, a high temperature of 1000 °C or higher is usually required, and as a result, the dopant which has been injected into the silicon substrate is differentially diffused by this thermal step, whereby the device characteristics tend to deteriorate (such a process is disclosed in JP-A (KOKAI; Unexamined Patent Publication) 55-134937, JP-A 59-4059, etc.).

As described above, the use of plasma has various advantages. On the other hand, however, when nitridation is conducted by using plasma, plasma damage can occur, and can deteriorate the device characteristics.

### Disclosure of Invention

An object of the present invention is to provide a process for producing materials for electronic device which can solve the above-mentioned problem encountered in the prior art.

Another object of the present invention is to provide a process which is capable of providing an electronic device structure comprising an extremely thin (e.g., having a film thickness of 2.5 nm or less) and high-quality oxide film and/or oxynitride film.

A further object of the present invention is to provide a process for producing materials for electronic device which can form an MOS-type semiconductor structure having an extremely thin (e.g., having a film thickness of 2.5 nm or less) and high-quality oxide film and/or oxynitride film.

According to the present invention, there is provided a process for producing electronic device material, wherein an oxide film (SiO₂ film) is formed on the surface of a substrate to be processed comprising Si as a main component in the presence of a process gas comprising at least O₂ and an inert gas, by using plasma based on microwave irradiation via a plane antenna member having a plurality of slits.

The present invention also provides a process for producing electronic device material, comprising:
a step of forming an underlying oxide film (SiO₂ film) in the presence of a process gas comprising at least O₂ and an inert gas, on the surface of a substrate to be processed comprising Si as a main component, by using plasma based on microwave irradiation via a plane antenna member having a plurality of slits; and
a step of nitriding the surface portion of the underlying SiO₂ film, in the presence of a process gas comprising at least N₂ and an inert gas, by using plasma based on microwave irradiation via a plane antenna member having a plurality of slits.

The present invention further provides a process for producing electronic device material, comprising:
a step of forming an underlying oxide film (SiO₂ film) in the presence of a process gas comprising at least O₂ and an inert gas, on the surface of a substrate to be processed comprising Si as a main component, by using plasma based on microwave irradiation via a plane antenna member having a plurality of slits;
a step of nitriding the surface portion of the underlying SiO₂ film, in the presence of a process gas comprising at least N₂ and an inert gas, by using plasma based on microwave irradiation via a plane antenna member having a plurality of slits; and
a step of forming an electrode layer on the SiO₂ film or the surface-nitrided underlying SiO₂ film (SiON film) by heating the substrate to be processed having the SiO₂ film or SiON film in the presence of a layer-forming gas.

### Brief Description of Drawings

Fig. 1 is a schematic vertical sectional view showing an example of the semiconductor device which can be produced by a process for producing an electronic device material according to the present invention.
Fig. 2 is a schematic plan view showing an example of the semiconductor manufacturing equipment for conducting a process for producing electronic device material according to the present invention.
Fig. 3 is a schematic vertical sectional view showing an example of the plasma processing unit comprising a slit plane (or planar) antenna (hereinafter, referred to as "SPA"), which is usable in the process for producing electronic device material according to the present invention.
Fig. 4 is a schematic plan view showing an example of the SPA which is usable in the apparatus for producing electronic device material according to the present invention.
Fig. 5 is a schematic vertical sectional view showing an example of the heating reaction furnace unit which is usable for the process for producing electronic device material according to the present invention.
Fig. 6 is a schematic process flow chart showing examples of the respective steps in the production process according to the present invention.
Fig. 7 is a schematic sectional view showing an example of the film formation by the production process according to the present invention.
Fig. 8 is a graph showing a leak characteristic of an MOS semiconductor structure which has been provided by the production process according to the present invention.
Fig. 9 is a graph showing a gate leakage current characteristic provided by a production process according to the present invention.
Fig. 10 is a graph showing results of the SIMS analysis of an oxynitride film provided by a production process according to the present invention.

In the above-mentioned figures, the respective reference numerals have the following meanings:
W: wafer (substrate to be processed), 60: SPA (plain antenna member), 2: oxide film, 2a: nitrogen-containing layer, 32: plasma processing unit (process chamber), 33: plasma processing unit (process chamber), 47: heating reaction furnace.

### Best Mode for Conducting the Invention

Hereinbelow, the present invention will be described in detail with reference to the accompanying drawings as desired. In the following description, "%" and "part(s)" representing a quantitative proportion or ratio are those based on mass, unless otherwise noted specifically.

### (Formation of oxide film)

In a preferred embodiment of the present invention, in the presence of a process gas (or a process gas atmosphere; this meaning is the same as in the description appearing hereinafter) comprising at least O₂ and an inert gas, an oxide film (SiO₂ film) can be formed on the surface of a substrate to be processed comprising Si as a main component, by use of plasma which is based on the microwave irradiation via (or through the medium of) a plane antenna member having a plurality of slits.

The substrate to be processed which is usable in the present invention is not particularly limited, as long as it comprises Si as a main component. For example, it is preferred to use a known substrate for an electronic device such as silicon (e.g., single-crystal silicon), and glass.

### (Process gas)

In the present invention, at the time of forming an oxide film, the process gas may comprise at least O₂ and an inert gas. The inert gas usable in this case is not particularly limited, but it is possible to use a gas (or a combination of two or more kinds of gases) which is appropriately selected from known inert gases. In view of the quality of a film, it is preferred to use an inert gas such as krypton, argon or helium.

### (Conditions for oxide film formation)

In an embodiment of the present invention wherein an oxide film is to be formed, in view of the characteristic of the oxide film to be formed, the following conditions may suitably be used:
O₂: 5-500 sccm, more preferably 50-500 sccm,
Inert gas (for example, krypton, argon or helium): 500-3000 sccm, more preferably 500-2000 sccm, particularly preferably 1000-2000 sccm, Temperature: room temperature (25 °C) to 700 °C, more preferably 200-700 °C, particularly preferably 200-500 °C,
Pressure: 20-5000 mTorr, more preferably 500-3000 mTorr, particularly preferably 1000-2000 mTorr,
Microwave: 0.5-5 W/cm², more preferably 0.5-4 W/cm2

### (Examples of suitable conditions)

In the present invention, in view of the characteristic of the oxide film to be formed, the following conditions may be raised as examples of the preferred conditions:

A preferred example of process gas: Gas comprising O₂ at a flow rate of 50-500 sccm, and krypton, argon or helium at a flow rate of 500-2000 sccm.

A preferred example of temperature in the formation of SiO₂ film: A temperature of 300-700 °C is exemplified.

As a preferred example of pressure in the formation of SiO₂ film, a pressure of 2.7-270 Pa (20-2000 mTorr) is exemplified.

As a preferred example of plasma in the formation of SiO₂ film, plasma which is formed by the output of 1-4 W/cm² is exemplified.

### (Nitridation of SiO₂ oxide film)

In the present invention, it is preferred to nitride an SiO₂ oxide film, as desired, by using nitriding plasma based on the microwave irradiation via a plane antenna member. The SiO₂ oxide film to be nitrided in this case is not particularly limited. In view of the film quality and productivity, it is preferred to use an underlying oxide film (SiO₂ film) which has been formed on the surface of a substrate to be processed comprising Si as a main component, by using plasma based on microwave irradiation via a plane antenna member in the presence of a process gas comprising an inert gas and O₂.

More specifically, in another preferred embodiment of the present invention, it is possible that an underlying oxide film (SiO₂ film) is formed on the surface of a substrate to be processed comprising Si as a main component, by using plasma based on microwave irradiation via a plane antenna member in the presence of a process gas comprising an inert gas and O₂; and then the surface of the above-mentioned underlying oxide film is nitrided by using plasma based on microwave irradiation via a plane antenna member in the presence of a process gas comprising at least an inert gas and N₂.

### (Process gas)

In above embodiment of the present invention for nitriding the SiO₂ oxide film, the process gas comprises at least N₂ and an inert gas. The inert gas usable in this case is not particularly limited, but it is possible to use a gas (or a combination of two or more kinds of gases) which is appropriately selected from known inert gases. In view of the quality of a film, it is preferred to use an inert gas such as krypton, argon or helium.

### (Conditions for nitriding oxide film)

In an embodiment of the present invention wherein an oxide film is to be formed, in view of the characteristic of the surface-nitrided oxide film to be formed, the following conditions may suitably be used:
N₂: 2-500 sccm, more preferably 4-200 sccm
Inert gas (for example, krypton, argon or helium): 200-2000 sccm, more preferably 500-2000 sccm, particularly preferably 1000-2000 sccm
H₂: 1-100 sccm, more preferably 2-50 sccm, particularly preferably 5-30 sccm
Temperature: room temperature (25 °C) to 700 °C, more preferably 200-500 °C
Pressure: 10-3000 mTorr, more preferably 20-1000 mTorr, particularly preferably 50-1000 mTorr
Microwave: 0.5-4 W/cm², more preferably 0.5-3 W/cm²

### (Examples of preferred conditions)

In the production process according to the present invention, in view of the characteristic of a surface-nitrided oxide film to be formed, the following conditions can be exemplified as preferred examples.

A preferred example of process gas in the nitridation of SiO₂ film: a gas comprising N₂ at a flow rate of 4-200 sccm, and krypton, argon or helium at a flow rate of 500-2000 sccm; or
a gas comprising N₂ at a flow rate of 4-200 sccm, krypton, argon or helium at a flow rate of 500-2000 sccm, and H₂ at a flow rate of 2-30 sccm.

A preferred example of temperature in the nitridation of SiO₂ film: a temperature of room temperature to 700 °C is exemplified.

A preferred example of pressure in the nitridation of SiO₂ film: a pressure of 2.7-135 Pa (20-1000 mTorr) is exemplified.

A preferred example of plasma in the nitridation of SiO₂ film: plasma which is formed by the output of 0.5-3 W/cm².

### (Embodiment of formation of electrode layer)

In the present invention, it is also possible to form an electrode layer on an SiO₂ film or an SiON film, as desired. As the electrode layer, in view of the device characteristics, it is preferred to use an electrode layer comprising poly-silicon or amorphous-silicon or SiGe. The underlying SiO₂ film or SiON film to be used for such a purpose is not particularly limited. In view of the film quality and productivity, it is preferred to use an underlying oxide film (SiO₂ film) which has been formed on the surface of a substrate to be processed comprising Si as a main component, by using plasma based on microwave irradiation via a plane antenna member in the presence of a process gas comprising at least an inert gas and O₂; or an SiON film which has been formed by using plasma based on microwave irradiation via a plane antenna member in the presence of a process gas comprising at least an inert gas and N₂.

More specifically, in a preferred embodiment of the present invention, it is possible that an underlying oxide film (SiO₂ film) is formed on the surface of a substrate to be processed comprising Si as a main component, by using plasma based on microwave irradiation via a plane antenna member having a plurality of slits, in the presence of a process gas comprising at least an inert gas and O₂;
the surface of the above-mentioned underlying SiO₂ film is nitrided by using plasma based on microwave irradiation via a plane antenna member having a plurality of slits, in the presence of a process gas comprising at least an inert gas and N₂; and
the substrate to be processed having the above-mentioned SiO₂ film or surface-nitrided underlying SiO₂ film (SiON film) is heated in the presence of a layer-forming gas, to thereby an electrode layer (for example, electrode layer comprising poly-silicon or amorphous-silicon or SiGe) on the above-mentioned SiO₂ film or SiON film.

### (Electrode-forming gas)

The electrode-forming gas which is usable in the present invention is not particularly limited. In accordance with the material and/or quality of an electrode layer to be formed, it is possible to use a gas by appropriately selecting either one of or a combination of at least two kinds of known electrode-forming gases.

When the electrode to be formed comprises poly-silicon, in view of the device characteristics and productivity, the electrode-forming gas may preferably comprise SiH₄. In this case, preferred electrode-forming conditions are as follows:
Pressure: 20.0-40 Pa (150-300 mTorr), more preferably 26-33.3 Pa (200-250 mTorr)
Temperature: 570-650 °C, more preferably 600-630 °C

When the electrode to be formed comprises amorphous-silicon, in view of the device characteristics and productivity, the electrode-forming gas may preferably comprise SiH₄. In this case, preferred electrode-forming conditions are as follows:
Pressure: 20.0-66.7 Pa (150-500 mTorr),
Temperature: 520-570 °C

When the electrode to be formed comprises SiGe, in view of the device characteristics, the electrode-forming gas may preferably comprise GeH₄/SiH₄. In this case, preferred electrode-forming conditions are as follows:
Gas composition: Mixed gas of GeH₄/SiH₄ = 10/90-60/40 %,
Pressure: 20-60 Pa,
Temperature: 460-560 °C

### (Plane antenna member)

The present invention is characterized in that a high-density plasma having a low electron temperature is generated by irradiating microwave via a plane antenna member having a plurality of slits; and the surface of a substrate to be processed is oxidized (as desired, nitrided) by utilizing the generated plasma. As a result, the present invention can provide a process which accomplishes a light plasma damage, and a high reactivity at a substrate low temperature.

For example, a paper (Ultra Clean Technology, Vol.10 Supplement 1, p.32, 1998, published by Ultra Clean Society) may be referred to, with respect to the details of microwave plasma apparatus which has such a plane antenna having many slits and is capable of generating plasma having a low electron temperature, providing a light plasma damage, and a high plasma density.

When the above new plasma apparatus is used, it can easily provide a plasma having an electron temperature of 1.5 eV or less, and plasma sheath voltage of several volts or less. Accordingly, in this case, the plasma damage can remarkably be reduced, as compared with that based on the conventional plasma (plasma sheath voltage of about 50V). A new plasma apparatus comprising this plane antenna is capable of providing high-density radicals even at a temperature of room temperature to about 700 °C, it is considered that it can suppress the deterioration of device characteristics due to heating, and it can provide a process having a high reactivity even at a low temperature.

On the other hand, even when plasma processing is used, the prior art has never provided a high-quality oxide film or oxynitride film having an extremely thin film thickness (e.g., oxide film or oxynitride film having various characteristics at a high level, such as those which are required for the next-generations MOS-type semiconductor structure) yet. For example, as the next-generations MOS-type semiconductor structure, there is demanded an MOS-type semiconductor structure having an oxide film or oxynitride film having a film thickness of 2.5 nm or less. In this case, in view of device characteristics, it is considered to be suitable to adopt an MOS-type semiconductor structure having a gate electrode such as that comprising poly-silicon, amorphous-silicon, or SiGe. However, in the prior art, there has never been found a process for producing a semiconductor structure having an extremely thin and high-quality oxide film or oxynitride film.

### (Preferred plasma)

The characteristics of the plasma which may preferably be used in the present invention are as follows.
Electron temperature: less than 2 eV
Density: 10¹¹-10¹³
Uniformity in plasma density: ± 3 % or less

As described above, the process according to the present invention can form a high-quality oxide film and/or oxynitride film having a small film thickness. Therefore, when another layer (for example, electrode layer) is formed on such an oxide film and/or an oxynitride film, a semiconductor device structure which is excellent in the characteristic may easily be formed.

In particular, the process according to the present invention can form a high-quality oxide film and/or oxynitride film having an extremely thin film thickness (for example, film thickness of 2.5 nm or less). Accordingly, for example, when poly-silicon or amorphous-silicon or Site is used as a gate electrode on this oxide film and/or oxynitride film, an MOS-type semiconductor structure having a high performance can be formed.

### (Preferred characteristic of oxide film)

The present invention can easily produce an oxide film having a preferred characteristic as descried below.
Physical film thickness: 0.8 nm to an arbitrary film thickness,
Leakage characteristic: one which is comparable to that of Dry Ox, to 1/10 times that of Dry Ox,
Film uniformity: ± 6 % or less

### (Preferred characteristic of oxynitride film)

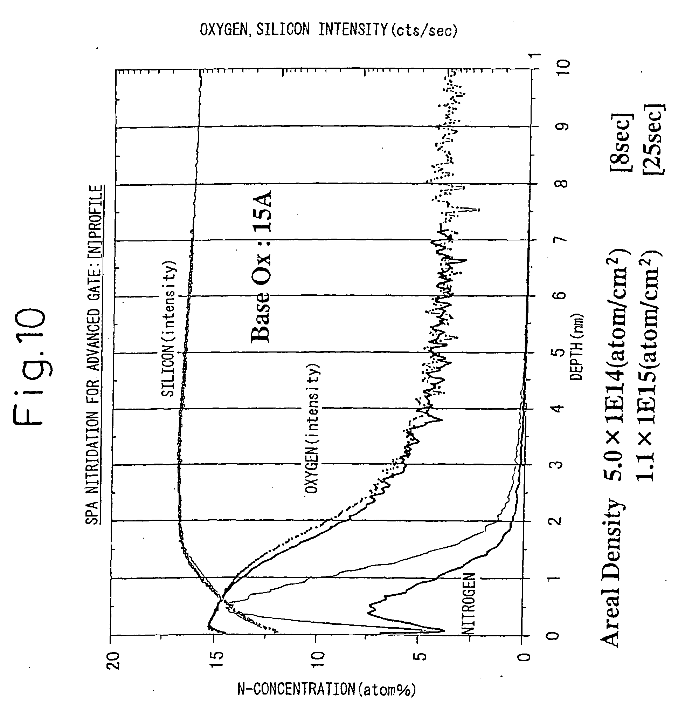

The present invention can easily produce an oxynitride film having a preferred characteristic as descried below.
Surface nitrogen concentration: at most 20% (as shown in Fig. 10)

Fig. 10 shows results of SIMS analysis of an oxide film which has been subjected to SPA-nitridation. In this analysis, nitridation was conducted on the underlying oxide film 15A for 8 seconds and 25 seconds, respectively. As shown in this figure, high-density nitrogen atoms are incorporated in the surface region, and it is possible to conduct nitriding while avoiding the deterioration of device characteristics due to the mixing of nitrogen atoms into the interface.

### (Preferred characteristic of MOS semiconductor structure)

The extent or range to which the production process according to the present invention is applicable is not particularly limited. The extremely thin high-quality oxide film and/or oxynitride film which can be formed by the present invention may particularly preferably be utilized as an insulator constituting a semiconductor device (particularly, gate insulator of an MOS semiconductor structure).

The present invention can easily produce an MOS semiconductor structure having a preferred characteristic as follows. When the characteristic of the oxide film and/or oxynitride film which has been formed by the present invention is evaluated, for example, instead of the evaluation of the physical property of the above-mentioned oxide film and/or oxynitride film per se, it is possible that a standard MOS semiconductor structure as described in a paper (OYO BUTURI (Applied Physics), Vol. 69, No. 9, pp. 1049-1059 (2000)) is formed, and the characteristic of the resultant MOS is evaluated. This is because, in such a standard MOS structure, the characteristic of the oxide film and/or oxynitride film constituting the structure has a strong influence on the resultant MOS characteristic.
Electric film thickness (equivalent oxide film thickness) 1.0-2.5 nm
Leakage characteristic: the leakage was reduced by a factor of a half to one digit, as compared with that of DryOx.
Uniformity in film thickness: ± 2 % or less

### (One embodiment of production apparatus)

Hereinbelow, a preferred embodiment of the production process according to the present invention is described.

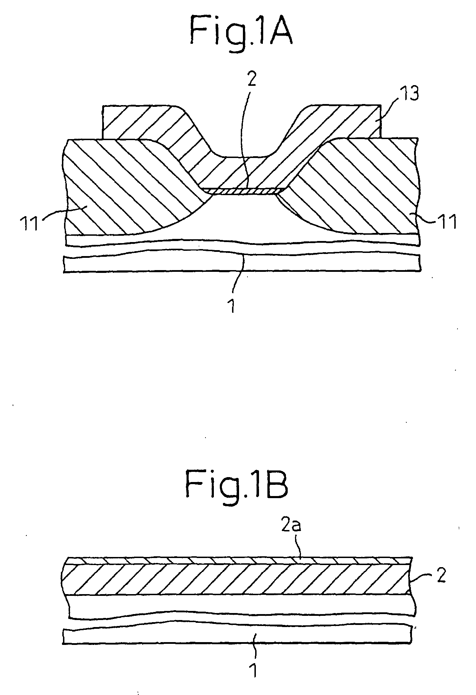

At first, as an example of the semiconductor device structure which can be produced by the process for producing electronic device material according to the present invention, there is described a semiconductor device having an MOS structure comprising a gate insulator as an insulating film with reference to Fig. 1.

Referring to Fig. 1A, the reference numeral 1 denotes a silicon substrate, the reference numeral 11 denotes a field oxide film, the reference numeral 2 denotes a gate insulator, and the reference numeral 13 denotes a gate electrode in Fig. 1A. As describe hereinabove, the production process according to the present invention can form an extremely thin and high-quality gate insulator 2. The gate insulator 2 comprises or consisting of a high-quality insulating film which has been formed at the interface thereof with the silicon substrate 1, as shown in Fig. 1B. For example, the gate insulator 2 comprises an oxide film 2 having a thickness of about 2.5 nm.

In this instance, the high-quality oxide film 2 may preferably comprise a silicon oxide film (hereinafter, referred to as "SiO₂ film") which has been produced by a method wherein a substrate to be processed comprising Si as a main component is irradiated with microwave via a plane antenna member having a plurality of .slits in the presence of a process gas comprising O₂ and an inert gas, to thereby generate plasma; and the SiO₂ film is formed on the surface of the above-mentioned substrate to be processed, by using the thus generated plasma. The use of such an SiO₂ film is, as described hereinafter, characterized in that interfacial quality (for example, interface state) between the respective films is good and it is easy to obtain a good gate leakage characteristic when an MOS structure having the SiO₂ film is constituted.

It is also possible to nitride the surface of the silicon oxide film 2, as desired. On the nitrided surface of the silicon oxide film 2, a gate electrode 13 comprising Si as a main component (poly-silicon or amorphous-silicon) is formed.

### (One embodiment of production process)

Next, there is described a process for producing an electronic device material which comprises such an silicon oxide film 2, a nitrided surface portion 2a, and a gate electrode 13 disposed thereon.

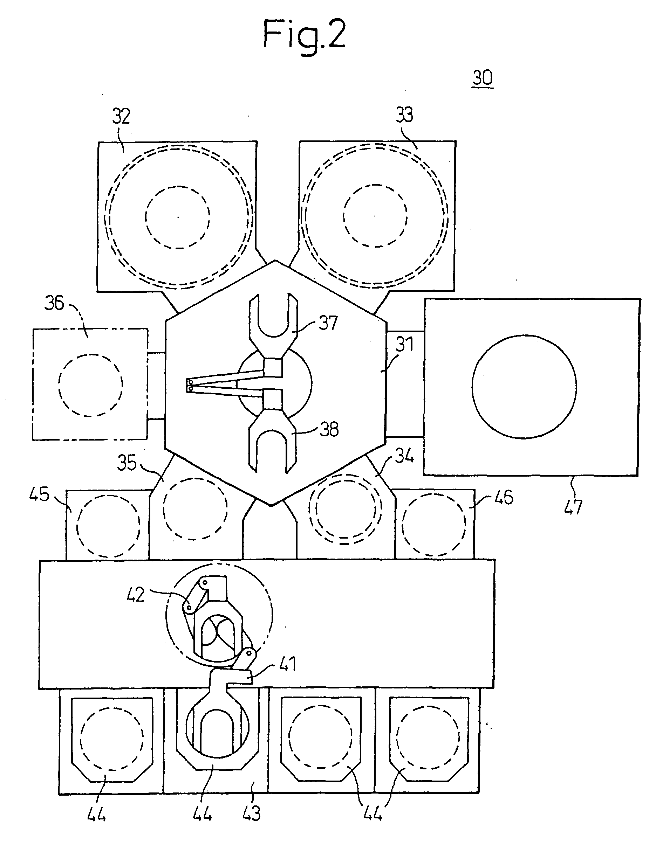

Fig. 2 is schematic view (schematic plan view) showing an example of the total arrangement of a semiconductor manufacturing equipment 30 for conducting the process for producing electronic device material according to the present invention.

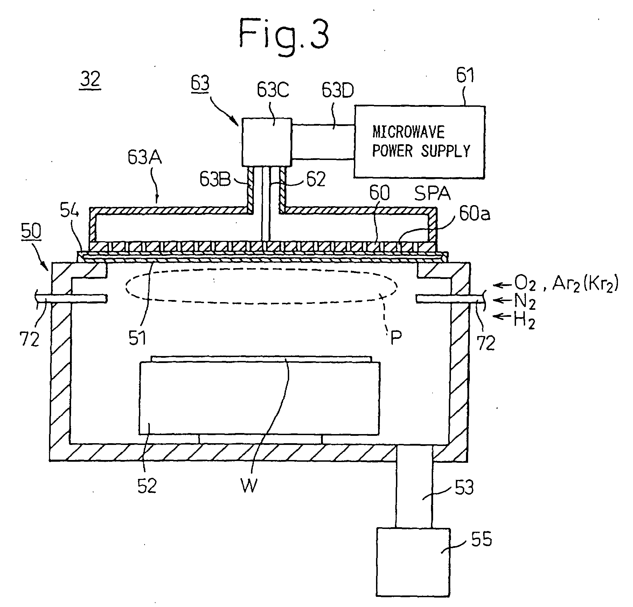

As shown in Fig. 2, in a substantially central portion of the semiconductor manufacturing equipment 30, there is disposed a transportation chamber 31 for transporting a wafer W (Fig. 3). Around the transportation chamber 31, there are disposed: plasma processing units 32 and 33 for conducting various treatments on the wafer, two load lock units 34 and 35 for conducting the communication/cutoff between the respective processing chambers, a heating unit 36 for operating various heating treatments, and a heating reaction furnace 47 for conducting various heating treatments on the wafer. These units are disposed so as to surround the transportation chamber 31. Alternatively, it is also possible to provide the heating reaction furnace 47 independently and separately from the semiconductor manufacturing equipment 30.

On the side of the load lock units 34 and 35, a preliminary cooling unit 45 and a cooling unit 46 for conducting various kinds of preliminary cooling and cooling treatments are disposed.

In the inside of transportation chamber 31, transportation arms 37 and 38 are disposed, so as to transport the wafer W (Fig. 3) between the above-mentioned respective units 32-36.

On the foreground side of the load lock units 34 and 35 in this figure, loader arms 41 and 42 are disposed. These loader arms 41 and 42 can put wafer W in and out with respect to four cassettes 44 which are set on the cassette stage 43, which is disposed on the foreground side of the loader arms 41 and 42.

In Fig. 2, as the plasma processing units 32 and 33, two plasma processing units of the same type are disposed in parallel.

Further, it is possible to exchange both of the plasma processing units 32 and 33 with a single-chamber type CVD process unit. It is possible to set one or two of such a single-chamber type CVD process unit in the position of plasma processing units 32 and 33.

When two plasma processing units 32 and 33 are used, it is possible that an SiO₂ film is formed in the plasma processing unit 32, and the SiO₂ film is surface-nitrided in the plasma processing unit 33. Alternatively, it is also possible that the formation of an SiO₂ film and the surface-nitriding of the SiO₂ film are conducted in parallel, in the plasma processing units 32 and 33. Further, it is also possible that an SiO₂ film is formed in another apparatus, and the SiO₂ film is surface-nitrided in parallel, in the plasma processing units 32 and 33.

### (One embodiment of film formation of gate insulator)

Fig. 3 is a schematic sectional view in the vertical direction showing a plasma processing unit 32 (or 33) which is usable in the film formation of the gate insulator 2.

Referring to Fig. 3, reference numeral 50 denotes a vacuum container made of, e.g., aluminum. In the upper portion of the vacuum container 50, an opening portion 51 is formed so that the opening portion 51 is larger than a substrate (for example, wafer W). A top plate 54 in a flat cylindrical shape made of a dielectric such as quartz and aluminum nitride is provided so as to cover the opening portion 51. In the side wall of the upper portion of vacuum container 50 which is below the top plate 54, gas feed pipes 72 are disposed in the 16 positions, which are arranged along the circumferential direction so as to provide equal intervals therebetween. A process gas comprising at least one kind of gas selected from O₂, inert gases, N₂, H₂, etc., can be supplied into the plasma region P in the vacuum container 50 from the gas feed pipes 72 evenly and uniformly.

On the outside of the top plate 54, there is provided a radio-frequency power source, via a plane antenna member having a plurality of slits, which comprises e.g., a slit plane antenna (SPA) made from a copper plate, for example. As the radio-frequency power source, a waveguide 63 is disposed on the top plate 54 by the medium of the SPA 60, and the waveguide 63 is connected to a microwave power supply 61 for generating microwave of 2.45GHz, for example. The waveguide 63 comprises a combination of: a flat circular waveguide 63A, of which lower end is connected to the SPA 60; a circular waveguide 63B, one end of which is connected to the upper surface side of the circular waveguide 63A; a coaxial waveguide converter 63C connected to the upper surface side of the circular waveguide 63B; and a rectangular waveguide 63D, one end of which is connected to the side surface of the coaxial waveguide converter 63C so as to provide a right angle therebetween, and the other end of which is connected to the microwave power supply 61.

In the present invention, a frequency region including UHF and microwave is referred to as radio-frequency (or high-frequency) region. The radio-frequency power supplied from the radio-frequency power source may preferably have a frequency of not smaller than 300 MHz and not larger than 2500 MHz, which may include UHF having a frequency of not smaller than 300 MHz and microwave having a frequency of not smaller than 1 GHz. In the present invention, the plasma generated by the radio-frequency power is referred to as "radio-frequency plasma".

In the inside of the above-mentioned circular waveguide 63B, an axial portion 62 of an electroconductive material is coaxially provided, so that one end of the axial portion 62 is connected to the central (or nearly central) portion of the SPA 60 upper surface, and the other end of the axial portion 62 is connected to the upper surface of the circular waveguide 63B, whereby the circular waveguide 63B constitutes a coaxial structure. As a result, the circular waveguide 63B is constituted so as to function as a coaxial waveguide.

In addition, in the vacuum container 50, a stage 52 for carrying the wafer W is provided so that the stage 52 is disposed opposite to the top plate 54. The stage 52 contains a temperature control unit (not shown) disposed therein, so that the stage can function as a hot plate. Further, one end of an exhaust pipe 53 is connected to the bottom portion of the vacuum container 50, and the other end of the exhaust pipe 53 is connected to a vacuum pump 55.

### (One embodiment of SPA)

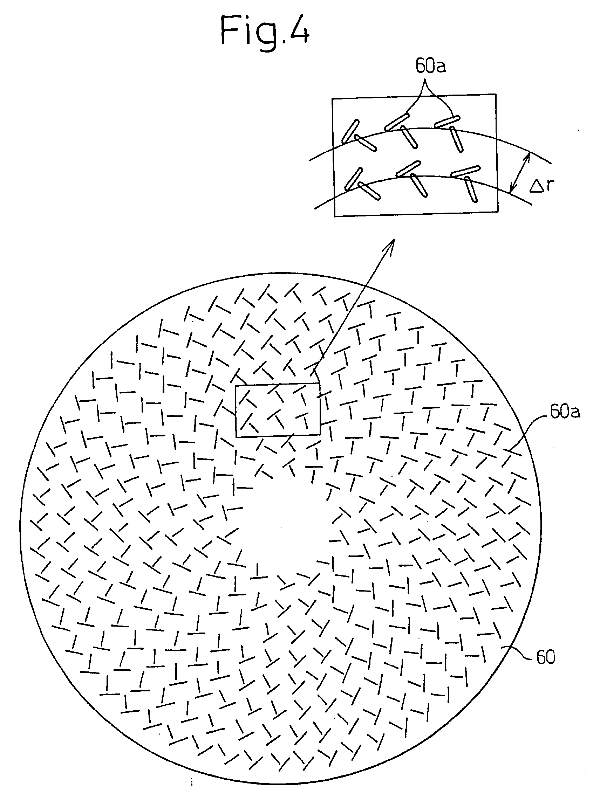

Fig. 4 is a schematic plan view showing an example of SPA 60 which is usable in an apparatus for producing an electronic device material according to the present invention.

As shown in this Fig. 4, on the surface of the SPA 60, a plurality of slots 60a, 60a, .... are provided in the form of concentric circles. Each slot 60a is a substantially square penetration-type groove. The adjacent slots are disposed perpendicularly to each other and arranged so as to form a shape of alphabetical "T"-type character. The length and the interval of the slot 60a arrangement are determined in accordance with the wavelength of the microwave supplied from the microwave power supply unit 61.

### (One embodiment of heating reaction furnace)

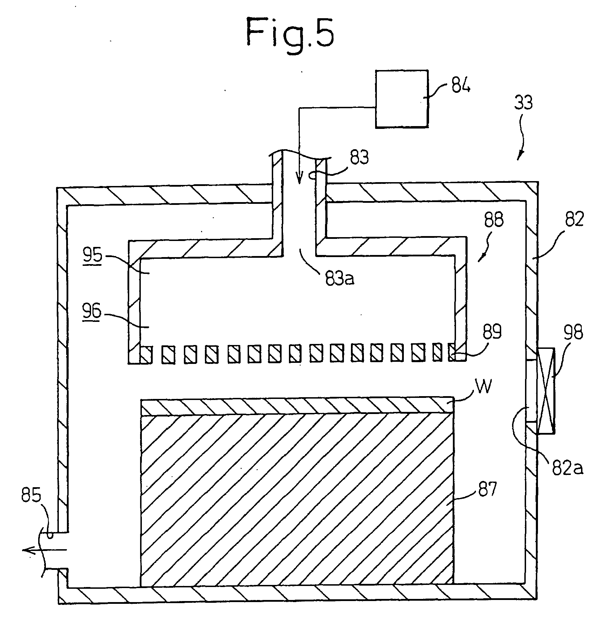

Fig. 5 is schematic sectional view in the vertical direction showing an example of the heating reaction furnace 47 which is usable in an apparatus for producing an electronic device material according to the present invention.

As shown in Fig. 5, a processing chamber 82 of the heating reaction furnace 47 chamber is formed into an air-tight structure by using aluminum, for example. A heating mechanism and a cooling mechanism are provided in the processing chamber 82, although these mechanisms are not shown in Fig. 5.

As shown in Fig. 5, a gas introduction pipe 83 for introducing a gas into the processing chamber 82 is connected to the upper central portion of the processing chamber 82, the inside of the processing chamber 82 communicates with the inside of the gas introduction pipe 83. In addition, the gas introduction pipe 83 is connected to a gas supply source 84. A gas is supplied from the gas supply source 84 into the gas introduction pipe 83, and the gas is introduced into the processing chamber 82 through the gas introduction pipe 83. As the gas in this case, it is possible to use one of various gases such as raw material for forming a gate electrode (electrode-forming gas) such as silane, for example. As desired, it is also possible to use an inert gas as a carrier gas.

A gas exhaust pipe 85 for exhausting the gas in the processing chamber 82 is connected to the lower portion of the processing chamber 82, and the gas exhaust pipe 85 is connected to exhaust means (not shown) such as vacuum pump. On the basis of the exhaust means, the gas in the processing chamber 82 is exhausted through the gas exhaust pipe 85, and the processing chamber 82 is maintained at a desired pressure.

In addition, a stage 87 for carrying wafer W is provided in the lower portion of the processing chamber 82.

In the embodiment as shown in Fig. 5, the wafer W is carried on the stage 87 by means of an electrostatic chuck (not shown) having a diameter which is substantially the same as that of the wafer W. The stage 87 contains a heat source means (not shown) disposed therein, to thereby constitute a structure wherein the surface of the wafer W to be processed which is carried on the stage 87 can be adjusted to a desired temperature.

The stage 87 has a mechanism which is capable of rotating the wafer W carried on the stage 87, as desired.

In Fig. 5, an opening portion 82a for putting the wafer W in and out with respect to the processing chamber 82 is provided on the surface of the right side of the processing chamber 82 in this figure. The opening portion 82a can be opened and closed by moving a gate valve 98 vertically (up and down direction) in this figure. In Fig. 5, a transportation arm (not shown) for transporting the wafer is provided adjacent to the right side of the gate valve 98. In Fig. 5, the wafer W can be carried on the stage 87, and the wafer W after the processing thereof is transported from the processing chamber 82, as the transportation arm enters the processing chamber 82 and goes out therefrom through the medium of the opening portion 82a.

Above the stage 87, a shower head 88 as a shower member is provided. The shower head 88 is constituted so as to define the space between the stage 87 and the gas introduction pipe 83, and the shower head 88 is formed from aluminum, for example.

The shower head 88 is formed so that the gas exit 83a of the gas introduction pipe 83 is positioned at the upper central portion of the shower head 88. The gas is introduced into the processing chamber 82 through gas feeding holes 89 provided in the lower portion of the shower head 88.

### (Embodiment of the insulating film formation)

Next, there is described a preferred embodiment of the process wherein an insulating film comprising a gate insulator 2 is formed on a wafer W by using the above-mentioned apparatus.

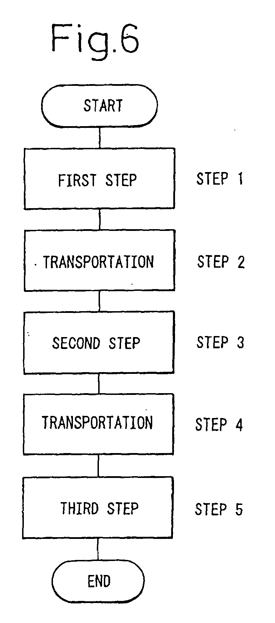

Fig. 6 is a schematic production process flowchart showing an example of the flow of the respective steps constituting the production process according to the present invention.

Referring to Fig. 6, in a preceding step, a field oxide film 11 (Fig. 1A) is formed on the surface of a wafer W.

Subsequently, a gate valve (not shown) provided at the side wall of the vacuum container 50 in the plasma processing unit 32 (Fig. 2) is opened, and the above-mentioned wafer W comprising the silicon substrate 1, and the field oxide film 11 formed on the surface of the silicon substrate 1 is placed on the stage 52 (Fig. 3) by means of transportation arms 37 and 38.

Next, the gate valve was closed so as to seal the inside of the vacuum container 50, and then the inner atmosphere therein is exhausted by the vacuum pump 55 through the exhaust pipe 53 so as to evacuate the vacuum container 50 to a predetermined degree of vacuum and a predetermined pressure in the container 50 is maintained. On the other hand, microwave (e.g., of 1.80 GHz and 2200 W) is generated by the microwave power supply 61, and the microwave is guided by the waveguide so that the microwave is introduced into the vacuum container 50 via the SPA 60 and the top plate 54, whereby radio-frequency plasma is generated in the plasma region P of an upper portion in the vacuum container 50.

Herein, the microwave is transmitted in the rectangular waveguide 63D in a rectangular mode, and is converted from the rectangular mode into a circular mode by the coaxial waveguide converter 63C. The microwave is then transmitted in the cylindrical coaxial waveguide 63B in the circular mode, and transmitted in the circular waveguide 63A in the expanded state, and is emitted from the slots 60a of the SPA 60, and penetrates the plate 54 and is introduced into the vacuum container 50. In this case, microwave is used, and accordingly high-density plasma can be generated. Further, the microwave is emitted from a large number of slots 60a of the SPA 60, and accordingly the plasma is caused to have a high plasma density.

Subsequently, while the wafer W is heated to 400 °C, for example, by regulating the temperature of the stage 52, the first step (formation of oxide film) is conducted by introducing via the gas feed pipe 72 a process gas for an oxide film formation comprising an inert gas such as krypton and argon, and O₂ gas at flow rates of 1000 sccm, and 20 sccm respectively.

In this process, the introduced process gas is activated (converted into plasma) by plasma flux which has been generated in the plasma processing unit 32, and on the basis of the thus generated plasma, as shown in the schematic sectional view of Fig. 7A, the surface of the silicon substrate 1 is oxidized, to thereby form an oxide film (SiO₂ film) 2. In this manner, the oxidation step is conducted for 40 seconds, for example, so that a gate oxide film or underlying oxide film form (underlying SiO₂ film) for forming a gate oxynitride film having a thickness of 2.5 nm can be formed.

Next, the gate valve (not shown) is opened, and the transportation arms 37 and 38 (Fig. 2) are caused to enter the vacuum container 50, so as to receive the wafer W on the stage 52. The transportation arms 37 and 38 take out the wafer W from the plasma processing unit 32, and then set the wafer W in the stage in the adjacent plasma processing unit 33 (step 2). Alternatively, depending on the application or usage of the wafer, it is also possible to transport the wafer to the heat reaction furnace 47 without nitriding the gate oxide film.

### (Embodiment of nitride-containing layer formation)

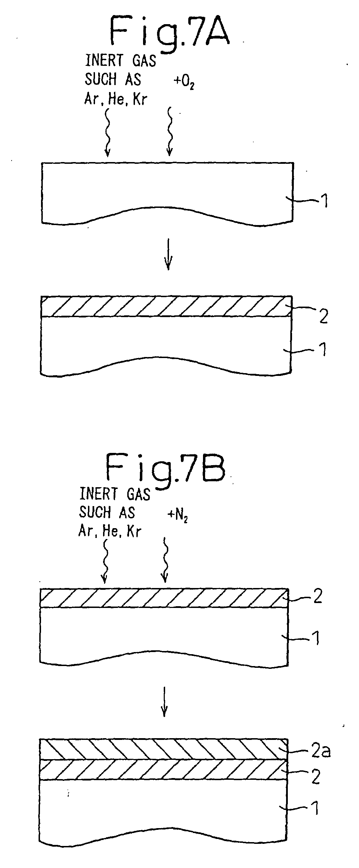

Subsequently, the wafer W is surface-nitrided in the plasma processing unit 33, and a nitride-containing layer 2a (Fig. 7 B) is formed on a surface portion of the underlying oxide (underlying SiO₂) film 2 which has been formed in advance.

At the time of the surface nitriding, for example, it is possible that argon gas and N₂ gas are introduced into the container 50 from the gas introduction pipe at flow rates of 1000 sccm and 20 sccm, respectively, in a state where the wafer temperature is 400 °C, for example, and the process pressure is 66.7 Pa (500 mTorr), for example, in the vacuum container 50.

On the other hand, microwave, e.g., of 2 W/cm² is generated from the microwave power supply 61, and the microwave is guided by the waveguide so that the microwave is introduced into the vacuum container 50 via the SPA 60 and the top plate 54, whereby radio-frequency plasma is generated in the plasma region P of an upper portion in the vacuum container 50.

In this process (surface nitriding), the introduced gas is converted into plasma, and nitrogen radicals are formed. These nitrogen radicals are reacted on the SiO₂ film disposed on the wafer W surface, to thereby nitride the SiO₂ film surface in a relatively short period. In this way, as shown in Fig. 7B, a nitrogen-containing layer 2a is formed on the surface of the underlying oxide film (underlying SiO₂ film) 2 on the wafer W.

It is possible that a gate oxynitride film (SiON film) having a thickness of about 2 nm in terms of the equivalent film thickness by conducting this nitriding treatment for 20 seconds, for example.

### (Embodiment of gate electrode formation)

Next, a gate electrode 13 (Fig. 1A) is formed on the SiO₂ film on the wafer W, or on the SiON film which has been formed by nitriding the underlying SiO₂ film on the wafer W. In order to form the gate electrode 13, the wafer W on which the gate oxide film or gate oxynitride film has been formed is taken out from each of the plasma processing unit 32 or 33, so as to once accommodate the wafer W in the transportation chamber 31 (Fig. 2) side, and then the wafer W is accommodated into the heating reaction furnace 47 (step 4). In the heating reaction furnace 47, the wafer W is heated under a predetermined processing condition to thereby form a predetermined gate electrode 13 on the gate oxide film or gate oxynitride film.

At this time, it is possible to select the processing condition depending on the kind of the gate electrode 13 to be formed.

More specifically, when the gate electrode 13 comprising poly-silicon is intended to be formed, the step is conducted under conditions such that SiH₄ is used as the process gas (electrode-forming gas), the pressure is 20.0-33.3 Pa (150-250 mTorr), and the temperature is 570-630 °C.

On the other hand, when the gate electrode 13 comprising amorphous-silicon is intended to be formed, the step is conducted under conditions such that SiH₄ is used as the process gas (electrode-forming gas), the pressure is 20.0-66.7 Pa (150-500 mTorr), and the temperature is 520-570 °C.

Further, when the gate electrode 13 comprising SiGe is intended to be formed, the step is conducted under conditions such that, a mixture gas of GeH₄/SiH₄ = 10/90-60/40 % is used, the pressure is 20-60 Pa, and the temperature is 460-560 °C.

### (Quality of oxide film)

In the above-mentioned first step, at the time of forming the gate oxide film or the underlying oxide film for gate oxynitride film, the wafer W comprising Si as a main component is irradiated with microwave in the presence of a process gas via a plane antenna member (SPA) having a plurality of slits, so as to form plasma comprising oxygen (O₂) and an inert gas, to thereby form the oxide film on the surface of the above-mentioned substrate to be processed. As a result, a high-quality film can be provided, and the control of the film quality can successfully be conducted.

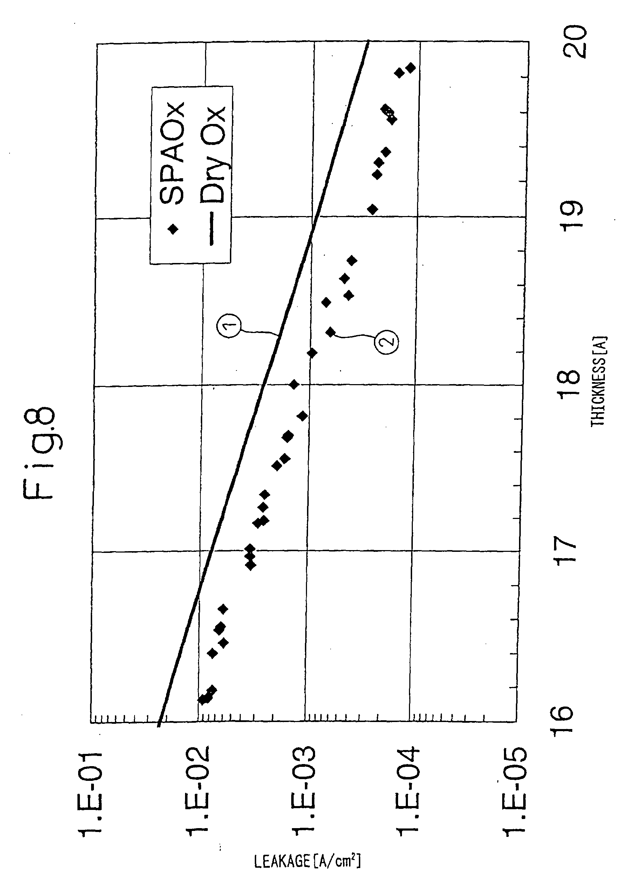

The quality of the oxide film in the first process is high as shown in the graph of Fig. 8.

The Fig. 8 shows the leakage characteristic of an MOS-type semiconductor structure which has been formed on a silicon wafer W by the process for producing the electronic device material regarding the above-mentioned embodiment. In this graph, the ordinate is the value of the leakage current, and the abscissa is the electric film thickness (equivalent film thickness).

In Fig. 8, the graph (1) shown by a solid line denotes the leakage characteristic of the thermal oxide film (DryOx) which has been formed by the conventional thermal oxidation process (Dry thermal oxidation process), for the purpose of comparison, and the graph (2) denotes the leakage characteristic of the oxide film (SPAOx) which has been obtained by the plasma processing by use of SPA in the presence of O₂ and argon as an inert gas.

As clearly understood from the graph of Fig. 8, the value of the leakage of the oxide film (2) which has been formed by the process for producing electronic device material according to the present invention is low, as compared with the leakage characteristic (1) of the thermal oxidation film which has been formed by the conventional thermal oxidation process. Therefore, a low power consumption is realized and good device characteristic can be obtained by using the oxide film formed by the present invention.

### (Presumed mechanism for high-quality oxide film)

As described above, as compared with those of the thermal oxide film, a high-quality oxide film (gate oxide film, for example) having a low interface state could be obtained by a process for producing electronic device material according to the present invention.

According to the present inventor's knowledge and investigations, the reason for the improvement in the film quality of the oxide film which has been formed by the above-mentioned process may be presumed as follows.

Thus, the plasma which has been formed by irradiating a process gas with microwave by use of an SPA is one having a relatively low electron temperature. Therefore, the bias between the plasma and the surface of the substrate to be processed can be suppressed to a relatively low value, and the plasma damage is light. Therefore, it is considered that an SiO₂ film having a good interfacial quality can be formed as shown in Fig. 8.

### (Presumed mechanism for high-quality oxynitride film)

In addition, the oxynitride film which has been obtained by the surface nitriding in the above-mentioned second step has an excellent quality. According to the present inventor's knowledge and investigations, the reason for such a film quality may be presumed as follow.

Thus, the nitrogen radicals which have been generated on the oxide film surface on the basis of the above-mentioned SPA have a high density, and therefore they can introduce nitrogen atoms in a surface portion of the oxide film, to thereby mix the nitrogen radicals therein at a concentration of several percents. In addition, as compared with the generation of nitrogen radicals by heat, high-density radicals can be generated even at a low temperature (around room temperature), whereby the deterioration in the device characteristic due to heat (represented by those due to the diffusion of a dopant) can be suppressed. Further, the nitrogen atoms in the film are incorporated in the surface portion of the oxide film, and accordingly, they can improve the dielectric constant and further can exhibit a certain performance (such as effect of preventing the penetration of boron atoms), without deteriorating the interfacial quality.

### (Presumed mechanism for preferred MOS characteristic)

Further, when the gate electrode is formed by the heat treatment under a specific condition in the above-mentioned third step, the resultant MOS-type semiconductor structure has an excellent characteristic. According to the present inventors' knowledge and investigations, the reason therefor may be presumed as follows.

In the present invention, as described above, an extremely thin high-quality gate insulator can be formed. Based on a combination of the high-quality gate insulator (gate oxide film and/or gate oxynitride film) and the gate electrode (for example, SiGe, amorphous-silicon, poly-silicon by CVD) which has been formed on the high-quality gate insulator, it is possible to realize a good transistor characteristic (such as good leakage characteristic).

Further, when a cluster-type apparatus as shown in Fig. 2 is used, the exposure of the gate insulator to the atmosphere can be avoided during a period between the formation of the gate oxide film or gate oxynitride film, and the formation of the gate electrode, to thereby further improve the yield and device characteristic.

### Examples

Hereinbelow, the present invention will be described in more detail with reference to Examples.

By a process for producing electronic device material according to the present invention, an underlying SiO₂ film having a film thickness of 1.8 nm was formed on an N-type silicon substrate which had been subjected to element-isolation formation, by means of an appratus shown in Fig. 2 by using SPA plasma in the process unit 32. The resultant total thickness was 1.8 nm in terms of oxide film thickness (equivalent film thickness). The conditions for the underlying SiO₂ film formation were: O₂/Ar₂ = 200 sccm/2000 sccm, a pressure of 2000 mTorr, a microwave power of 3 W/cm², and a temperature of 400 °C.

The conditions for nitriding the underlying SiO₂ film were: N₂/Ar₂ flow rate = 40 sccm/1000 sccm, a pressure of 7 Pa (50 mTorr), a microwave of 2 W/cm², and a temperature of 400 °C. The nitridation time was changed so as to provide values of 10 seconds, 20 seconds, and 40 seconds. A throughput of 25 sheets/hour per one chamber was achieved, and it was confirmed that such a throughput was sufficiently applicable to an industrial use.

Subsequently to the gate insulator formation, a P-type poly-silicon gate electrode was formed, and the equivalent film thickness was determined from the resultant C-V characteristic. As a result, the equivalent film thickness was decreased to about 1.4 nm, and the uniformity in the film thickness was 4 % in terms of three-sigma, whereby good results were provided.

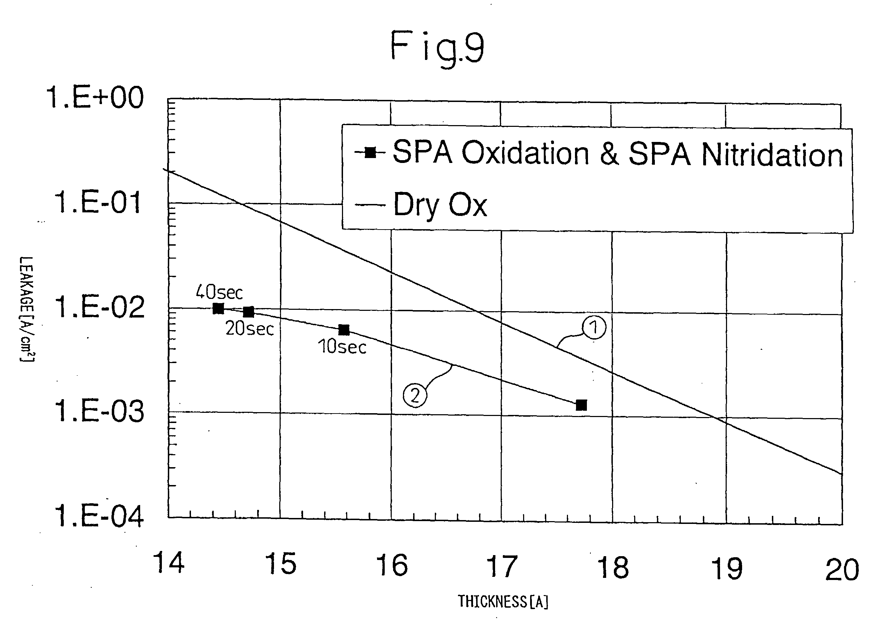

Further, the gate leakage current characteristic was measured. In Fig. 9, the ordinate is the leakage current characteristic, and the abscissa is the electric film thickness (equivalent film thickness). The graph (1) shown by a straight line denotes the leakage characteristic of a normal (or standard) thermal oxide film, and the graph (2) shown by points denotes the leakage characteristic of a film which had been obtained by nitridation after the SPA oxidation. As shown by the graph (2), a reduction in the equivalent film thickness was observed along with an increase in the nitridation period. In addition, under the nitridation condition of 40 seconds, the leakage current was decreased by a factor of about one digit, at most, as compared with that of the normal thermal oxide film.

As described hereinabove, the process for producing electronic device material according to the present invention could provide a high-performance MOS-type semiconductor structure having a good electric characteristic at a throughput which is sufficiently applicable to an industrial use.

### Industrial Applicability

As described hereinabove, by use of a process for producing an electronic device according to the present invention, a substrate to be processed comprising Si as a main component is irradiated in the presence of a process gas with microwave via a plane antenna member having a plurality of slits (so-called SPA antenna), whereby plasma is directly supplied to the silicon-containing substrate to form an oxide film (SiO₂ film). As a result, the present invention can preferably control the characteristic of the interface (or boundary) between the silicon-containing substrate and the oxide film (SiO₂ film) to be foomed thereon.

Further, by use of another embodiment of the process for producing an electronic device according to the present invention, an underlying oxide film (SiO₂ film) is subjected to surface-nitriding by using a so-called SPA antenna, to thereby form a high-quality oxynitride film (SiON film).

Further, when a gate electrode (for example, gate electrode comprising poly-silicon or amorphous-silicon or SiGe) is formed on the thus formed high-quality oxide film and/or oxynitride film, whereby an semiconductor structure (for example, MOS-type semiconductor structure) having a good electric characteristic can be formed.

## Claims

1. A process for producing electronic device material, wherein an oxide film (SiO₂ film) is formed on the surface of a substrate to be processed comprising Si as a main component in the presence of a process gas comprising at least O₂ and an inert gas, by using plasma based on microwave irradiation via a plane antenna member having a plurality of slits.

2. A process for producing electronic device material according to claim 1, wherein the electronic device is a semiconductor device.

3. A process for producing electronic device material according to claim 2, wherein the oxide film is a gate oxide film (SiO₂ film) or an underlying oxide film (underlying SiO₂ film) for a gate oxynitride film.

4. A process for producing electronic device material according to any one of claims 1-3, wherein the oxide film has a thickness of 2.5 nm or less.

5. A process for producing electronic device material according to any one of claims 1-4, wherein the inert gas is at least one selected from krypton, argon and helium.

6. A process for producing electronic device material according to any one of claims 1-5, wherein the process gas comprises O₂ at a flow rate of 5-500 sccm, and krypton, argon or helium at a flow rate of 500-3000 sccm.

7. A process for producing electronic device material according to any one of claims 1-6, wherein the SiO₂ film is formed at a temperature of room temperature to 700 °C.

8. A process for producing electronic device material according to any one of claims 1-4, wherein the SiO₂ film is formed at a pressure of 20-5000 mTorr.

9. A process for producing electronic device material according to any one of claims 1-8, wherein the plasma is generated by an output of 0.5-5 W/cm².

10. A process for producing electronic device material, comprising:
a step of forming an underlying oxide film (SiO₂ film) in the presence of a process gas comprising at least O₂ and an inert gas, on the surface of a substrate to be processed comprising Si as a main component, by using plasma based on microwave irradiation via a plane antenna member having a plurality of slits; and
a step of nitriding the surface portion of the underlying SiO₂ film, in the presence of a process gas comprising at least N₂ and an inert gas, by using plasma based on microwave irradiation via a plane antenna member having a plurality of slits.

11. A process for producing electronic device material according to claim 10, wherein the electronic device is a semiconductor device.

12. A process for producing electronic device material according to claim 10 or 11, wherein the process gas further comprises H₂.

13. A process for producing electronic device material according to any one of claims 10-12, wherein the oxide film is a gate oxide film (SiO₂ film) or an underlying oxide film (underlying SiO₂ film) for a gate oxynitride film.

14. A process for producing electronic device material according to any one of claims 10-13, wherein the oxide film has a thickness of 2.5 nm or less.

15. A process for producing electronic device material according to any one of claims 10-14, wherein the inert gas is at least one selected from krypton, argon and helium.

16. A process for producing electronic device material according to any one of claims 10-15, wherein the process gas comprises N₂ at a flow rate of 2-500 sccm, and krypton, argon or helium at a flow rate of 200-2000 sccm; or comprises N₂ at a flow rate of 2-500 sccm, and krypton, argon or helium at a flow rate of 200-2000 sccm, and H at a flow rate of 1-100 sccm.

17. A process for producing electronic device material according to any.one of claims 10-16, wherein the underlying SiO₂ film is nitrided at a temperature of room temperature to 700 °C.

18. A process for producing electronic device material according to any one of claims 10-17, wherein the underlying SiO₂ film is nitrided at a pressure of 10-3000 mTorr.

19. A process for producing electronic device material according to any one of claims 10-18, wherein the nitriding plasma is generated by an output of 0.5-4 W/cm².

20. A process for producing electronic device material, comprising:
a step of forming an underlying oxide film (SiO₂ film) in the presence of a process gas comprising at least O₂ and an inert gas, on the surface of a substrate to be processed comprising Si as a main component, by using plasma based on microwave irradiation via a plane antenna member having a plurality of slits;
a step of nitriding the surface portion of the underlying SiO₂ film, in the presence of a process gas comprising at least N₂ and an inert gas, by using plasma based on microwave irradiation via a plane antenna member having a plurality of slits; and
a step of forming an electrode layer on the SiO₂ film or the surface-nitrided underlying SiO₂ film (SiON film) by heating the substrate to be processed having the SiO₂ film or SiON film in the presence of a layer-forming gas.

21. A process for producing electronic device material according to claim 20, wherein the electrode layer comprises poly-silicon or amorphous-silicon or SiGe.

22. A process for producing electronic device material according to claim 20 or 21, wherein the electronic device is a semiconductor device.

23. A process for producing electronic device material according to any one of claims 20-22, wherein the electrode layer is a gate electrode.

24. A process for producing electronic device material according to any one of claims 20-23, wherein the layer-forming gas is SiH₄, the pressure is 20.0-40 Pa (150-300 mTorr), and the temperature is 570-650 °C, and the gate electrode to be formed comprises poly-silicon.

25. A process for producing electronic device material according to any one of claims 20-23, wherein the layer-forming gas is SiH₄, the pressure is 20.0-66.7 Pa (150-500 mTorr), the temperature is 520-570 °C, and the gate electrode to be formed comprises amorphous-silicon.

26. A process for producing electronic device material according to any one of claims 20-23, wherein the layer-forming gas is a mixed gas of GeH₄/SiH₄ = 10/90-60/40 %, the pressure is 20-60 Pa, the temperature is 460-560 °C, he gate electrode to be formed comprises SiGe.
